# EUROPEAN PATENT SPECIFICATION

(11) **EP 3 006 596 B1**
(45) Date of publication and mention of the grant of the patent: **03.01.2018**
(21) Application number: 14804632.9
(22) Date of filing: 08.05.2014
(51) Int. Cl.: C23C 14/56, C23C 16/54, H01J 37/32, H01L 21/67, H01J 37/34

(54) **DEPOSITION DEVICE**
ABSCHEIDUNGSVORRICHTUNG
DISPOSITIF DE DÉPÔT

(30) Priority: 31.05.2013 JP 2013115045
(43) Date of publication of application: 13.04.2016
(73) Proprietor: Kabushiki Kaisha Kobe Seiko Sho (Kobe Steel, Ltd.), Kobe-shi, Hyogo 651-8585 (JP)
(72) Inventor: SEGAWA, Toshiki, Takasago-shi, Hyogo 676-8670 (JP); OHBA, Naoki, Takasago-shi, Hyogo 676-8670 (JP); KUROKAWA, Yoshinori, Takasago-shi, Hyogo 676-8670 (JP)
(74) Representative: TBK
(86) International application number: PCT/JP2014/062363
(87) International publication number: WO 2014/192514

(56) References cited:
- EP-A1- 2 518 761
- WO-A1-2012/086119
- GB-A- 1 503 301
- JP-A- H11 350 136
- JP-A- 2005 220 434
- JP-A- 2006 077 284
- JP-A- 2006 322 055
- JP-A- 2010 053 382
- JP-A- 2012 136 724
- JP-A- 2013 049 916
- US-A1- 2005 172 898

## Description

### TECHNICAL FIELD

The present invention relates to a continuous deposition device for forming thin films such as functional thin films on a surface of a belt-shaped film substrate.

### BACKGROUND ART

Conventionally, as a device for continuously performing deposition to a thin film substrate made of a long film or sheet, there is known a device which continuously conveys the film substrate within a vacuum chamber, and deposits various functional thin films on a surface thereof by sputtering or vapor deposition.

For example, as such a deposition device, Patent Document 1 discloses a device provided with an upper chamber and lower chamber. The lower chamber houses a deposition roller around which a film substrate made of a film or the like can be wound, and a plurality of sputter sources for performing deposition treatment to the film substrate, and the like. The lower chamber has right and left side walls, openings are formed in these side walls, and doors for opening and closing the openings are attached to the side walls. In a state that the doors are open, various kinds of maintenance works such as replacement of targets, replacement and cleaning of masks partitioning a deposition area, and so-called feeding and replacement of the film substrate for each batch processing are performed through the openings.

The upper chamber is arranged above the lower chamber and houses a feeding unit for feeding the film substrate, a degassing unit for heating the fed film substrate and separating gas from the film substrate, and a take-up unit for taking up the film substrate. In the device, the film substrate fed from the feeding unit in the upper chamber passes through the degassing unit and then is once carried in the lower chamber, and after deposition treatment is performed therein, it is returned to the upper chamber and taken up by the take-up unit.

Thus, process units except the deposition roller and peripheral equipment thereof are housed in the upper chamber, thereby a space for performing works such as the above maintenances is secured on the right and left sides.

In the above-mentioned conventional device, there is a need to secure sufficient work spaces respectively on the outer sides of the right and left doors of the lower chamber, and thus other units cannot be arranged at positions adjacent to the right and left of the lower chamber, therefore the upper chamber is arranged on the further upper side of the lower chamber, and the feeding unit to be arranged on the upstream side of the deposition roller, the degassing unit, and the take-up unit to be arranged on the downstream side of the deposition roller must be housed in the upper chamber. This leads to complexity of assembly work and difficulty in maintenance work of the entire device. Specifically, when assembling the device, a large-scale work in which, in a state that the heavy upper chamber is lifted by means of a hoist or the like, the lower chamber is installed below and is coupled to the upper chamber is required, but this work is not easy. Moreover, in replacement or maintenance of each part within the upper chamber, a worker has to work by accessing the upper chamber from the upper side of the upper chamber at a high position, so facility cost for scaffolding for that work and security assurance increases. Patent Document 2 discloses a film forming device, wherein an elongated substrate is fed from a first roll chamber in a first direction toward a second roll chamber via a heating chamber and film formation chambers. Patent Document 3 discloses a continuous film-forming apparatus wherein the vacuum chamber has a cylindrical chamber main body having left and right openings, which can be opened and closed.

### CITATION LIST

### PATENT DOCUMENT

Patent Document 1: JP 2010-053382 A
Patent Document 2: EP 2 518 761 A1
Patent Document 3: WO 2012/086119 A1

### SUMMARY OF THE INVENTION

An object of the present invention is to provide a deposition device provided with a plurality of units including a deposition unit, capable of securing a wide work space for replacement or maintenance of each deposition process device equipped in the deposition unit while arranging these units without overlapping them up and down.

The deposition device according to the present invention is defined in claim 1.

It should be noted that a "horizontal" used in the present invention is not strictly defined, and is a concept including directions somewhat inclined to a complete horizontal plane.

### BRIEF DESCRIPTION OF DRAWINGS

[Fig. 1] Fig. 1 is a sectional front view of a deposition device according to an embodiment of the present invention and is a sectional view taken along the line I-I of Fig. 4.
[Fig. 2] Fig. 2 is a sectional front view showing a substantial part of the deposition device.
[Fig. 3] Fig. 3 is a sectional view taken along the line III-III of Fig. 1.
[Fig. 4] Fig. 4 is a plan view of the deposition device.

### DESCRIPTION OF EMBODIMENTS

Hereinafter, preferred embodiments of the present invention will be described with reference to the drawings.

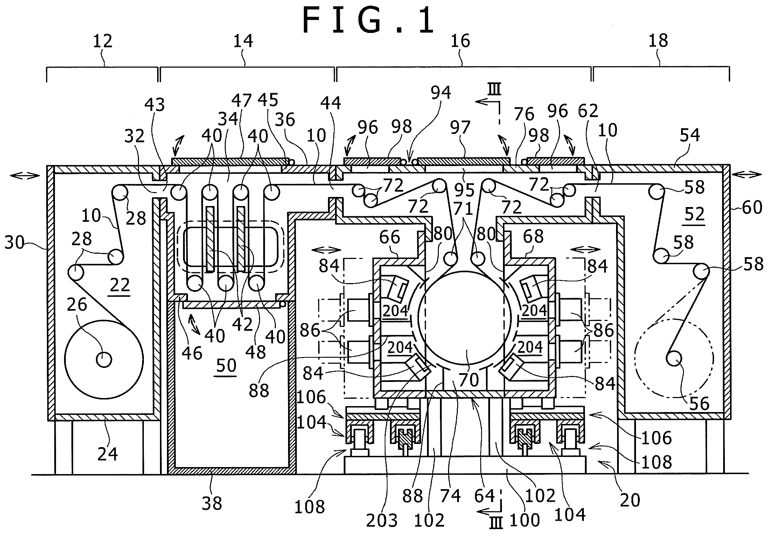

A deposition device shown in Fig. 1 is a device for forming a thin film on a surface of a long belt-shaped film substrate 10 made of for example a plastic film while conveying the film substrate 10 in the longitudinal direction thereof. The deposition device is provided with a feeding unit 12, a degassing unit 14, a deposition unit 16, and a take-up unit 18 in order of process of the film substrate 10. The units 12, 14, 16, and 18 are sequentially arranged along the horizontal direction which is the conveying direction of the film substrate 10. In the device, the horizontal direction (including the directions somewhat inclined) orthogonal to a rotation center axis X of a deposition roller 70 described later and the direction parallel to the rotation center axis X correspond respectively to the right and left direction and the front and back direction, and the respective units 12, 14, 16, and 18 are arranged in this order in the right and left direction (the direction from left to right in Fig. 1).

The feeding unit 12 supplies the film substrate 10, and is provided with a feeding roll 26, a plurality of free rollers 28 each acting as a guide roller, a feeding chamber 24 surrounding a supplying space 22, and a door 30. The feeding roll 26 is housed in the lower part of the feeding chamber 24, and feeds the film substrate 10 wound around the feeding roll 26 by rotation of the feeding roll 26. The respective free rollers 28 are arranged above the feeding roll 26 within the feeding chamber 24, and guide the film substrate 10 fed from the feeding roll 26 to an outlet 32 provided in the upper part of the feeding chamber 24. The feeding chamber 24 has an opening which opens the supplying space 22 to the outside of the feeding chamber 24, and the door 30 is mounted to the feeding chamber 24 via a hinge so as to open and close the opening. The opening is used for replacement of the feeding roll 26, so-called feeding of the film substrate 10, and other maintenance works.

The degassing unit 14 heats the fed film substrate 10 and separates gas contained therein from the film substrate 10 as a pretreatment process of deposition, and is provided with a plurality of free rollers 40, a plurality of plate heaters 42, a degassing chamber 36 surrounding a degassing space 34, and a support frame 38 arranged on the lower side of the degassing chamber 36, and the free rollers 40 and the plate heaters 42 are housed in the degassing chamber 36.

The degassing chamber 36 has an inlet 43 connected to the outlet 32 of the feeding unit 12, and an outlet 44 located on the opposite side thereof. The support frame 38 supports the degassing chamber 36 at a height position where the inlet 43 and the outlet 32 coincide. The degassing chamber 36 includes a top lid 45 and a bottom lid 46 which are located up and down, the top and bottom lids are formed with openings for maintenance respectively, and doors 47, 48 for opening and closing the openings are mounted thereto via a hinge. The support frame 38 surrounds a work space 50 where the worker can enter the lower part of the degassing chamber 36, in order to enable the work from the opening provided in the bottom lid 46.

The respective free rollers 40 are alternately arranged up and down so as to guide the film substrate 10 from the inlet 43 to the outlet 44 while conveying the film substrate 10 up and down within the degassing chamber 36. The respective plate heaters 42 are arranged in a vertically standing posture between adjacent portions to each other in the right and left direction among the film substrate 10 advancing in the right and left direction while being conveyed in the up and down direction as described above, and the plate heaters 42 heat the film substrate 10 by own heat generation and perform the degassing treatment.

The deposition unit 16 performs deposition treatment (sputtering in the present embodiment) on a surface of the film substrate 10 introduced from the feeding unit 12 via the degassing unit 14, and the details thereof will be described in detail later.

The take-up unit 18 takes up the film substrate 10 to which deposition is performed in the deposition unit 16, and is provided with a take-up chamber 54 surrounding a take-up space 52, a take-up roll 56 and a plurality of free rollers 58 housed in the take-up chamber 52, and a door 60. The take-up roll 56 is housed in the lower part of the take-up chamber 54, and the film substrate 10 introduced from the deposition unit 16 is sequentially taken-up by rotation of the take-up roll 56. The respective free rollers 58 are arranged above the take-up roll 56, and guide the film substrate 10 introduced into the take-up space 52 from an inlet 62 provided in the upper part of the take-up chamber 54 to the take-up roll 56. The take-up chamber 54 has an opening which opens the take-up space 52 to the outside of the take-up chamber 54, and the door 60 is mounted to the take-up chamber 54 via a hinge so as to open and close the opening. The opening is used for replacement of the take-up roll 56, so-called feeding of the film substrate 10, and other maintenance works.

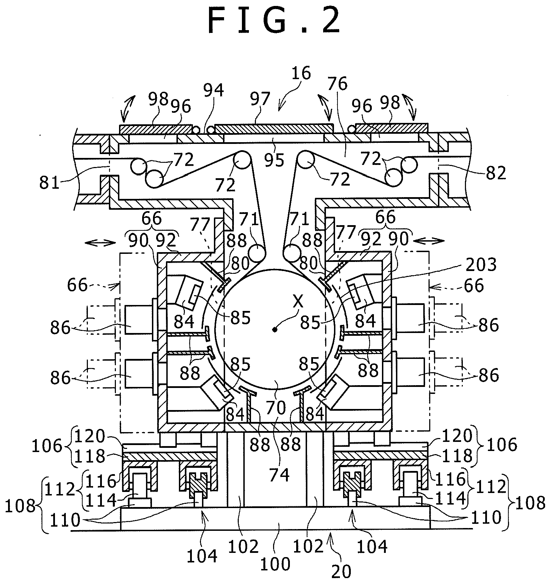

Next, the details of the deposition unit 16 will be described with reference to Figs. 2 to 4.

The deposition unit 16 is provided with a main chamber 64, a left process chamber (first process chamber) 66, a right process chamber (second process chamber) 68, a deposition roller 70, a plurality of free rollers including right and left auxiliary rollers 71 and a plurality of guide rollers 72, a plurality of deposition process devices including sputter sources 84 and pressure separating partitions 88 (described later), and a chamber support unit 20 including process chamber support units 104.

The main chamber 64 is formed by integrally joining a deposition roller housing unit 74 and a guide roller housing unit 76, and constitutes a main chamber unit together with the housed articles thereof. As the housed articles, the deposition roller housing unit 74 houses the deposition roller 70, the auxiliary rollers 71, a plurality of deposition masks 203, and some of the pressure separating partitions 88, and the guide roller housing unit 76 houses the guide rollers 72.

The deposition roller housing unit 74 has right and left first chamber opening side surfaces 77, and the respective opening side surfaces 77 are formed with a large opening 80 respectively. An interior space of the deposition roller housing unit 74 can communicate with interior spaces of the left and right process chambers 66, 68 through the respective openings 80.

The guide roller housing unit 76 is located on the upper side of the deposition roller housing unit 74 and has a shape which is longer than the deposition roller housing unit 74 in the right and left direction, that is, the direction parallel to the conveying direction of the film substrate 10. In other words, both ends in the right and left direction of the guide roller housing unit 76 protrude in the right and left direction than the deposition roller housing unit 74. The end faces of these portions correspond to the second chamber opening side surfaces, and the second chamber opening side surfaces are formed with an inlet 81 and an outlet 82 of the main chamber 64 respectively. The chamber support unit 20 supports the main chamber 64 at a height position where the inlet 81 and the outlet 82 are connected to the outlet 44 of the degassing unit 14 and the inlet 62 of the take-up unit 18 respectively.

The main chamber 64 shown in Figs. 1 and 2 is integrally formed as a whole, but the present invention is not limited thereto. For example, on the grounds of production, the deposition roller housing unit 74 and the guide roller housing unit 76 are formed separately and then may be coupled.

The deposition roller 70 has a cylindrical outer peripheral surface centered on the rotation center axis X parallel to the front and back direction of the device as mentioned above, and is supported by the deposition roller housing unit 74 so as to be rotatable around the axis X in a state that the film substrate 10 is set so as to be wound on the outer peripheral surface.

The partitions 88 housed in the deposition roller housing unit 74 divide the space around the deposition roller 70 into a plurality of deposition zones 204 and separate pressure of the respective deposition zones 204 from each other, together with the partitions 88 housed in the first and second process chambers 66, 68 as described later. Moreover, the respective deposition masks 203 having an opening are arranged in the vicinity of the outer peripheral surface of the deposition roller 70, and restrict a deposition area such that a sputtering film deposits only to the portions corresponding to the openings of the respective deposition masks 203 among the film substrate 10.

The right and left auxiliary rollers 71 are arranged in a position immediately above the deposition roller 70, and guide the film substrate 10 such that the film substrate 10 winds on the surface except the upper end portion among the outer peripheral surface of the deposition roller 70. These auxiliary rollers 71 may be housed in the guide roller housing unit 76 rather than the deposition roller housing unit 74. Moreover, each auxiliary roller 71 may be used as a tension detection roller for detecting the tension of the film substrate 10.

The guide rollers 72 are arranged so as to align in the right and left direction within the guide roller housing unit 76. Some of the guide rollers 72 are arranged so as to guide the film substrate 10 from the degassing unit 14 to the deposition roller 70, and the remainder is arranged so as to guide the film substrate 10 from the deposition roller 70 to the take-up unit 18. The guide rollers 72 may include a driving water-cooled roller.

In addition, every rollers included in the deposition device are arranged so as to be rotatable around the axis parallel to the rotation center axis X of the deposition roller 70 (that is, the axis extending in the front and back direction of the device), and the film substrate 10 is conveyed in the direction orthogonal to these axes.

The left and right process chambers 66, 68 are arranged so as to close from the right and left outer sides the openings 80 provided in the right and left opening side surfaces 77 of the deposition roller housing unit 74, and form a deposition space, that is, a plurality of deposition zones 204 divided by the partitions 88, around the deposition roller 70 in cooperation with the deposition roller housing unit 74. The respective process chambers 66, 68 house at least some of the deposition process devices, and constitute a process chamber unit movable with respect to the main chamber unit together with the housed articles thereof. The respective deposition process devices are arranged along the outer peripheral surface of the deposition roller 70, and perform a deposition process to the film substrate 10 moving on the outer peripheral surface of the deposition roller 70 in the rotation direction thereof.

The deposition process devices housed in the process chambers 66, 68 according to the present embodiment include a plurality of sputter sources 84, a plurality of turbo molecular pumps 86, some of the plurality of partitions 88, a cold trap (not shown), and the like. The respective sputter sources 84 hold targets 85 for sputtering and are arranged respectively within the deposition zones 204 surrounded respectively by the partitions 88 provided in a plurality of positions within the deposition unit 16, and sputter a part of the target 85 on the surface of the film substrate 10 on the outer peripheral surface of the deposition roller 70 via the deposition masks by application of a high voltage in a predetermined atmosphere of argon gas or the like. Each turbo molecular pump 86 operates such that the interiors of the process chambers 66, 68 are evacuated.

The respective process chambers 66, 68 are formed in a shape which opens inwardly, that is, a box shape which opens toward the deposition roller 70 and the deposition roller housing unit 74 which houses it. Specifically, the respective process chambers 66, 68 have outside walls 90 located on the right and left outer sides respectively, and a peripheral wall 92 extending inwardly from the periphery of the outside walls 90. Therefore, the right and left first chamber opening side surfaces 77 of the deposition roller housing unit 74 coincide with the openings on the deposition roller housing unit 74 side of the respective process chambers 66, 68.

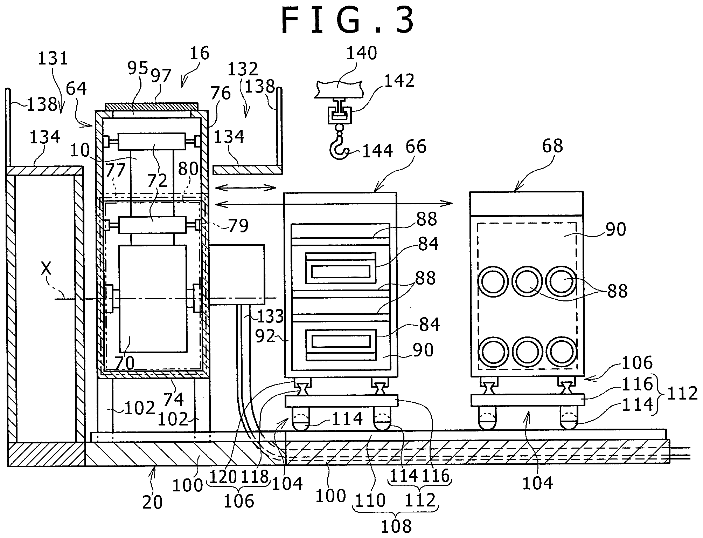

The respective process chambers 66, 68 are allowed to move between the regular position shown by a solid line in Fig. 2 and the retracted position shown by a chain double-dashed line in Fig. 2 while being supported by the chamber support unit 20 described in detail later. In the regular position, the respective process chambers 66, 68 close the openings 80 (in the present embodiment, inner end faces of the peripheral walls 92 of the respective process chambers 66, 68 adhere to each other while sandwiching a seal member 79 (Fig. 3) arranged around the openings 80 therebetween), thereby sealing the interior of the deposition roller housing unit 74 and forming the plurality of deposition zones 204 in cooperation with the deposition roller housing unit 74.

The retracted position is a position where the process chambers 66, 68 retract from the regular position to the outer sides in the right and left direction with a slight stroke, and is a position where interference of the process chambers 66, 68 and the deposition roller 70 can be avoided in a case where the process chambers 66, 68 move in the front and back direction from that position. The stroke from the regular position to the retracted position is set large enough to allow the process chambers 66, 68 to move in the front and back direction from the retracted position without interfering with the deposition roller 70, and is set small enough to be capable of avoiding the interference of the respective process chambers 66, 68 and the units adjacent to the right and left outer sides respectively (in the present embodiment, the degassing unit 14 being the upstream unit and the take-up unit 18 being the downstream unit) in the retracted position.

In the present embodiment, the sputter sources 84, the turbo molecular pumps 86, and many of the partitions 88 are fixed to the outside walls 90 and the peripheral walls 92 of the process chambers 66, 68 respectively, and the remainder of the partitions 88 is fixed to the inner wall of the main chamber 64.

The guide roller housing unit 76 has a top lid 94, and in the top lid 94, a plurality of openings (in the present embodiment, a central opening 95 and right and left openings 96) are formed and doors 97, 98 for opening and closing the respective openings 95, 96 respectively are mounted thereto via a hinge. The openings 95, 96 allow the worker to access from above to the respective guide rollers 72 through these openings 95, 96 by opening the respective guide rollers 72 housed in the guide roller housing unit 76 upwardly.

The chamber support unit 20 has a base 100 installed on the ground, a plurality of struts 102 arranged in a standing condition on the base 100, and right and left process chamber support units 104 assembled on the base 100 and including guide rails 110 described later and the like. The struts 102 support the main chamber 64 among the deposition unit 16 in a stationary state. The right and left process chamber support units 104 support the left and right process chambers 66, 68 so as to be movable between the regular position and the retracted position which is retracted from the regular position respectively.

Each process chamber support unit 104 includes a first support unit 106 and a second support unit 108. Each first support unit 106 guides the process chambers 66, 68 in the right and left direction orthogonal to the center axis of the deposition roller 70, thereby respectively supporting the process chambers 66, 68 so as to allow the process chambers 66, 68 to move between the regular position, that is, the position where the respective process chambers 66, 68 close the openings 80 of the main chamber 64 respectively, and the retracted position which is retracted to both outer sides in the right and left direction from the regular position. Each second support unit 108 supports the respective process chambers 66, 68 and the first support units 106 supporting them so as to be movable in the front and back direction parallel to the center axis of the deposition roller 70 respectively, thereby allowing the process chambers 66, 68 to move between a position (for example, the retracted position) where the process chambers 66, 68 face to the respective openings 80 and an exposure position which is separated in the front and back direction (both in the back direction, in the present embodiment) from that position to expose the interiors of the process chambers 66, 68.

Each second support unit 108 according to the present embodiment has a pair of guide rails 110 and a pair of traveling bodies 112. Each guide rail 110 is laid on the base 100 so as to extend in the front and back direction. Each traveling body 112 travels along each rail 110 while supporting the first support units 106 from below. Specifically, the traveling bodies 112 have a plurality of wheels 114 capable of rolling on the respective guide rails 110, and a traveling table 116 holding the wheels 114 so as to be rotatable around the axis in the right and left direction, and the first support units 106 are supported on the traveling tables 116. Each traveling body 112 may be equipped with a self-traveling motor driving the wheels 114, and may be driven by a drive mechanism (for example, a ball screw mechanism) provided in the exterior of the traveling body 112. Alternatively, the traveling bodies 112 may be powered by man power or auxiliary power therefor.

Each first support unit 106 has a pair of front and rear slide supporting members 118, and a plurality of sliders 120 fixed to the bottom faces of the respective process chambers 66, 68. Each slide supporting member 118 extends in the right and left direction, and is installed on the traveling tables 116 so as to bridge over the right and left traveling tables 116 in positions separated from each other in the front and back direction. Each slider 120 consists of, for example, an LM guide or the like and engages with the slide supporting member 118 so as to be slidable along the longitudinal direction (that is, the right and left direction of the device) of the slide supporting member 118, thereby supporting the corresponding process chamber 66 or 68 slidably to the right and left direction. Sliding of the process chambers 66, 68 may be performed, for example, by expansion and contraction in the right and left direction of cylinders coupled to the process chambers 66, 68, or by a manual operation by the worker.

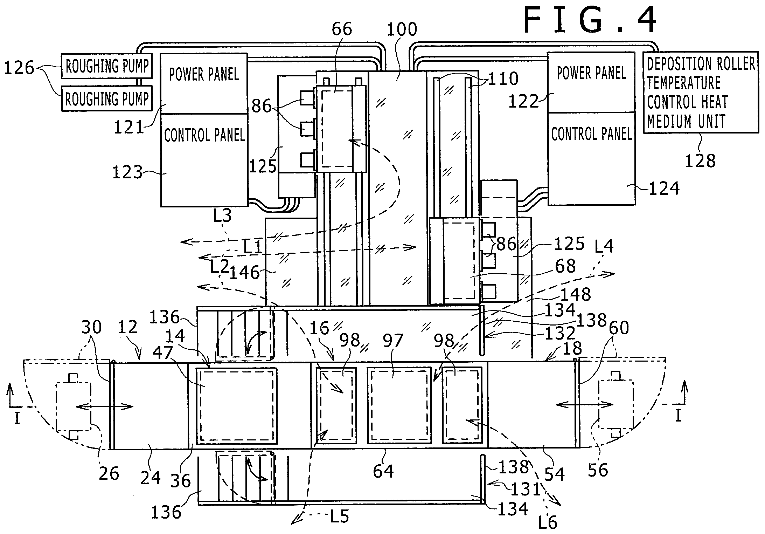

Thus, the process chamber support units 104 allow the respective process chambers 66, 68 to move between the regular position (the deposition position shown in Figs. 1 and 2) and the exposure position (the position where the process chambers 66, 68 are completely separated backwardly from the main chamber 64 to expose the interiors of the process chambers 66, 68 as shown in Figs. 3 and 4).

The exposure position is a position for maintenance or the like of the deposition unit 16 and is not necessarily set to a certain position. Preferably, the moving stroke of the process chamber is set such that at least one process chamber of the first and second process chambers 66, 68 can be separated in the front and back direction from the main chamber 64 by a distance larger than the dimension in the front and back direction of the other process chamber. In the example shown in Figs. 3 and 4, each stroke is set large enough such that both process chambers 66, 68 can be separated from the main chamber 64 by a distance more than the dimension in the front and back direction of the process chambers 66, 68, in other words, such that both process chambers 66, 68 can be positioned so as to simultaneously separate from the main chamber 64 and so as not to overlap with each other in the right and left direction, for example, as shown in Figs. 3 and 4.

The deposition device according to the present embodiment is provided with additional equipment including left and right power panels 121, 122, left and right control panels 123, 124, left and right movable wire housing units 125, 126, a plurality of roughing pumps 128, and a deposition roller temperature control unit 130 shown in Fig. 4, in addition to the above-mentioned components, and all of them are arranged in the area behind the deposition unit 16, that is, the area on the side where the exposure positions of both process chambers 66, 68 exist.

The respective power panels 121, 122 and the control panels 123, 124 are connected to suitable devices within the deposition unit 16. The roughing pumps 128 are connected to the turbo molecular pumps 86 of the deposition unit 16 through roughing pipes (not shown). In the present embodiment, the roughing pipes are coupled to each other when the process chambers 66, 68 operating in the closing direction toward the regular position are coupled to the main chamber 64. The deposition roller temperature control unit 130 is connected to the deposition roller 70 through a temperature control pipe 133 shown in Fig. 3, and controls the temperature of the deposition roller 70 by circulation of a heat medium. The respective movable wire housing units 125, 126 are attached to the respective process chambers 66, 68 so as to move integrally therewith respectively, and house the pipes and the wires to be connected to the process chambers 66, 68 together. Energization of each sputter source 84 is realized, for example, by a socket insertion structure (not shown) whose connection is switched to on or off in conjunction with the opening and closing operation of the process chambers 66, 68. The roughing pumps 128 and the deposition roller temperature control unit 130 may be arranged in the vicinity of a body portion of the deposition device as shown in Fig. 4, or may be provided in another chamber separated from the body portion.

Further, the deposition device is provided with front and rear scaffolding units 131, 132 as shown in Figs. 3 and 4. These units 131, 132 form a scaffolding respectively on the front and back of the deposition unit 16 and the degassing unit 14, and have a foot board 134 arranged in a suitable height position, stairs 136 for going up and down the foot board 134, a safety fence 138, and the like. These scaffolding units 131, 132 allow the worker to perform works of feeding in the main chamber 64 and maintenance of each roller through the openings 95, 96 which are upper openings of the guide roller housing unit 76 in the main chamber 64.

As shown in Fig. 3, above the space behind the deposition unit 16, that is, the space on the side where the exposure positions of the respective process chambers 66, 68 exist, a hoist 142 is provided. The hoist 142 is mounted to a ceiling frame 140 of the factory so as to be movable in the horizontal direction (at least the right and left direction) along the ceiling frame 140, and performs lifting of the targets 85 or the like of relatively large weight (for example, about 40-50 kg) via a hook 144. In the present embodiment, the hoist 142 is installed above the intermediate position between the position where the first process chamber 66 exists as shown in Figs. 3 and 4, that is, the position where the process chamber retracts with a full stroke (the position where the second process chamber 68 exists as shown in Figs. 3 and 4), and the main chamber 64 so as to be movable in the right and left direction, and hoisting and conveying works of the targets 85 or the like with the use of the hoist 142 are performed at the intermediate position. As to these works, the base 100 also functions as a scaffolding. In addition to the base 100, scaffolding foot stools 146, 148 as shown in Fig. 4 can be appropriately added.

Next, the action of the deposition device will be described.

Firstly, when performing deposition, the respective process chambers 66, 68 of the deposition unit 16 are set to the regular position shown in Figs. 1 and 2, that is, the position where these process chambers 66, 68 close the right and left openings of the deposition roller housing unit 74 of the main chamber 64 and form a deposition space together with the deposition roller housing unit 74. In this state, the film substrate 10 is conveyed in the right and left direction in order of the feeding unit 12, the degassing unit 14, the deposition unit 16, and the take-up unit 18, and in the deposition unit 16, deposition treatment to the surface of the film substrate 10 is performed. The deposition treatment is performed by the deposition roller 70 and deposition process devices arranged therearound (specifically, the sputter sources 84 and the turbo molecular pumps 86 housed in the process chambers 66, 68, the deposition masks 203 housed in the deposition roller housing unit 74, or the like).

In replacement or maintenance of parts related to the deposition unit 16, the right and left process chamber units, that is, the units consisting of the process chambers 66, 68 and the housed articles thereof are moved to the exposure positions shown in Figs. 3 and 4 for example from the regular position, while leaving the main chamber unit, that is, the unit consisting of the main chamber 64 and the housed article thereof included in the deposition unit 16. This movement is realized by moving the respective process chambers 66, 68 to the retracted position which is slightly separated in the right and left outer sides from the regular position along the slide supporting members 112 of the first support units 106, and by moving them by a sufficient distance in the front and back direction (in the present embodiment, backwardly) along the guide rails 110 of the second support units 108 from the retracted position, that is, moving them to the exposure positions where the interiors of the process chambers 66, 68 completely expose. In this state, works related to the moved process chamber units, that is, works related to the deposition process devices inside the process chambers, such as works of replacement of the targets 85 held by the sputter sources 84 or cleaning of the partitions 88 are possible, and works related to the main chamber unit through the openings 80 of the main chamber 64 opened by the movement of the process chambers, such as replacement of the deposition masks 203 for each batch, cleaning of the deposition roller 70 or the auxiliary roller 71, and the like are possible.

Such works may be sequentially performed as to the left and right process chambers 66, 68, but working efficiency is further enhanced by simultaneously moving these process chambers 66, 68 to the exposure positions. Furthermore, if the moving stroke of the process chambers 66, 68 is set large enough, for example as shown in Figs. 3 and 4, sufficiently large work spaces as to both process chambers 66, 68 can be secured by moving one process chamber (the left process chamber 66 in Figs. 3 and 4) to the backmost position and moving the other process chamber (the right process chamber 68 in Figs. 3 and 4) to the intermediate position which is a position between the one process chamber and the main chamber 64 and where the other chamber does not overlap with these chambers in the right and left direction (that is, where the chambers do not interfere with each other).

For example, in the arrangement shown in Figs. 3 and 4, the worker can access to the right process chamber 68 existing in the intermediate position from the left side of the device in the route shown by a broken line L1, and carry-in and carry-out of the targets 85 or the like can be performed along the same route by using the hoist 142 provided in the intermediate position. The articles to be carried in and to be carried out can be transported between a faraway place of the deposition device and the foot stool 146 by using, for example, a carriage (not shown). Moreover, in the opposite route thereto, as to the left process chamber 66, that is, the process chamber separated from the main chamber 64 to the position which completely exceeds the right process chamber 68, works such as maintenance can be performed similarly. Specifically, in a state shown in Fig. 4 for example, the worker can access to the left process chamber 66 in the route shown by a broken line L3. Further, carry-in and carry-out of the deposition masks 203 or the like can be performed in the route shown by a broken line L2 in Fig. 4 through the openings 80 of the main chamber 64 opened by the movement of the process chambers 66, 68. Moreover, by arranging the left and right process chambers 66, 68 oppositely to the arrangement shown in Fig. 4, carry-in and carry-out of the opposite masks 203 or the like can be performed, for example, in the route shown by a broken line L4. Further, carry-in and carry-out of the deposition masks 203 can be also performed, for example, in the routes shown by broken lines L5, L6, from the front side of the device.

The present invention is not limited to the embodiments described above.

For example, the directions of the movements in the front and back direction of the respective process chambers 66, 68 may be set to opposite directions to each other. For example, the guide rails 110 may be laid such that the left process chamber 66 moves to the front side and the right process chamber 68 moves to the back side. However, by unifying the directions of the movements of both process chambers 66, 68, for example, by setting both directions to the back side as shown in Figs. 3 and 4, the occupied space of the entire device can be significantly reduced, and the working efficiency of works such as maintenance as to the respective process chambers 66, 68 can be further enhanced.

The device according to the present embodiment may include a plurality of deposition units 16. In this case, these deposition units 16 may be arranged so as to align in the right and left direction as shown in Figs. 1 and 2, for example.

Moreover, the upstream unit and the downstream unit according to the present invention are not limited specifically. In the embodiments shown in Figs. 1 to 4, based on the deposition unit 16, the degassing unit 14 corresponds to the upstream unit and the take-up unit 18 corresponds to the downstream unit, but the feeding unit 12 may correspond to the upstream unit if the degassing unit 14 is omitted. On the contrary, in a case where an aftertreatment unit for performing treatment after deposition exists, the aftertreatment unit may correspond to the downstream unit

Whatever units the upstream and downstream units are, the present invention exhibits an effect of securing a sufficient work space for maintenance or the like while compactly arranging these units on the right and left sides of the deposition unit without arranging them on the upper side thereof. Specifically, in the present invention, although the process chambers constituting the deposition unit are required to move in the right and left direction from the regular position thereof to the retracted position, the retracted position is sufficient as long as it is a position slightly separated from the regular position to such an extent that interference of the process chambers and the deposition roller or the like associated with the movement in the front and back direction of the process chambers can be avoided, and therefore the upstream and downstream units can be arranged in positions adjacent to the right and left sides of the deposition unit. Furthermore, by moving the process chambers largely in the front and back direction from the retracted position to the exposure position, works such as maintenance can be performed without hindrance, as to both of the process chambers and the remaining main chamber.

As described above, the present invention provides a deposition device provided with a plurality of units including a deposition unit, capable of securing a wide work space for replacement or maintenance of each deposition process device equipped in the deposition unit while arranging these units without overlapping them up and down. The deposition device performs deposition on a surface of a belt-shaped film substrate extending in a specific direction while conveying the film substrate in the longitudinal direction thereof, and is provided with a deposition unit, an upstream unit arranged on the upstream side in the conveying direction of the film substrate than the deposition unit, and a downstream unit arranged on the downstream side in the conveying direction of the film substrate than the deposition unit. The deposition unit has a deposition roller rotatable around a horizontal rotation center axis, a plurality of deposition process devices arranged around the deposition roller, a plurality of guide rollers arranged so as to guide the film substrate between the upstream and downstream units and the deposition roller, a main chamber having a deposition roller housing unit which houses the deposition roller and a guide roller housing unit which is located on the upper side thereof and houses at least a part of the guide rollers, first and second process chambers which are arranged respectively on both sides of the deposition roller housing unit with respect to the right and left direction orthogonal to the direction of the center axis of the deposition roller, house respectively at least a part of the deposition process devices, and have openings facing the deposition roller housing unit side, and process chamber support units for supporting the first and second process chambers. The deposition roller housing unit has right and left first chamber opening side surfaces which are located on both sides in the right and left direction of the deposition roller and coincide with the openings on the deposition roller housing unit side of the first and second process chambers. The guide roller housing unit has portions extending to both sides in the right and left direction than the right and left first chamber opening side surfaces of the deposition roller housing unit, and these portions have right and left second chamber opening side surfaces respectively connected to the upstream unit and the downstream unit. The process chamber support units support the first and second process chambers so as to be movable between a regular position where the process chambers cover the openings of the deposition roller housing unit and form a deposition space together with the main chamber and a retracted position where the process chambers retract to the outer sides in the right and left direction within a range inside the upstream unit and the downstream unit from the regular position, and between the retracted position and an exposure position which is separated from the retracted position in the front and back direction parallel to the rotation center axis of the deposition roller and from which the interiors of the process chambers expose.

According to the deposition device, it is possible to sufficiently secure a space necessary for works of maintenance or replacement of each device included in the deposition unit, such as the deposition roller or a deposition process container while arranging the upstream unit and the downstream unit on the right and left sides of the deposition unit rather than on the upper side of the deposition unit with respect to the deposition unit.

Specifically, in the device, the chamber constituting the deposition unit is divided into the main chamber having the deposition roller housing unit and the guide roller housing unit, and the first and second process chambers, and the first and second process chambers are movable in the front and back direction between the retracted position which retracts to the outer sides in the right and left direction thereof from the regular position for deposition and the exposure position where the interiors of the first and second process chambers expose. Therefore, by respectively moving the first and second process chambers to the exposure position, that is, the position separated in the front and back direction from the main chamber and the upstream and downstream units, a maintenance work or a replacement work of each deposition process device housed in the first and second process chambers (for example, a replacement work or a cleaning work of a target or a shield plate) can be performed, and works related to the deposition roller housing unit (for example, works of cleaning or maintenance of the deposition roller or the like housed in the deposition roller housing unit, or a replacement work of the deposition mask or the like) can be performed through the openings of the first chamber opening side surface and a space for these works can be sufficiently secured.

Meanwhile, the movement amount of the process chambers in the right and left direction from the regular position to the retracted position may be small such an extent that movement in the front and back direction from the retracted position to the exposure position is permitted (that is, to such an extent that interference of the process chambers and the deposition roller or the like can be avoided when moving in the front and back direction thereof), so the upstream and downstream units can be arranged in positions adjacent to both sides in the right and left direction with respect to the deposition unit while avoiding interference of the process chambers and the upstream and downstream units.

Therefore, according to the device, a work space necessary for maintenance or replacement of each device included in the deposition unit can be sufficiently secured, by effectively using a space in the front and back direction of the deposition unit, while compactly arranging the deposition unit and the upstream and downstream units thereof in the right and left direction.

Moreover, the chamber constituting the deposition unit is divided into the main chamber and the first and second process chambers, thereby the chamber clears transportation limits relating to weight, shape, and size easily.

Preferably, the process chamber support units support the first and second process chambers so as to allow the process chambers to move to the same side with respect to the front and back direction from the retracted position respectively. Thus, the first and second process chambers move to the same side with respect to the front and back direction, that is, the exposure positions of the respective first and second process chambers are on the same side, thereby capable of concentrating equipment necessary for maintenance or the like of the deposition process devices housed in these process chambers and spaces for movement thereof on the same side with respect to the front and back direction. This enables reduction of the occupied space of the entire device and enhancement of working efficiency of maintenance or the like.

In this case, preferably, the process chamber support units support the first and second process chambers so as to allow at least one process chamber of the first and second process chambers to move away from the main chamber in the front and back direction by a distance larger than the dimension of the front and back direction of the other process chamber. Thereby, both process chambers can move simultaneously to the same side of the front and back direction from the respective retracted positions and these chambers can be located so as not to overlap with each other in the right and left direction, that is, one process chamber of the first and second process chambers can move to a position completely exceeding the position of the other process chamber with respect to the front and back direction. According to this arrangement, it is possible to access to the first and second process chambers simultaneously and easily, so works such as maintenance related to them can be performed simultaneously and efficiently without interference with each other of these process chambers.

Favorably, the process chamber support units include first support units which support the first and second process chambers so as to allow the process chambers to move in the right and left direction between the regular position and the retracted position, and second support units which support the first support units so as to allow the process chambers to move in the front and back direction between the retracted position and the exposure position. The process chamber support units realize the movement of each process chamber from the regular position to the exposure position by a combination of the first support units and the second support units.

Preferably, the guide roller housing unit has upper openings which open each guide roller housed in the guide roller housing unit upwardly, and the deposition device is further provided with scaffolding units which are arranged on at least one side in the front and back direction of the main chamber and used for performing works by a worker through the upper openings. By this configuration, the worker can access to the guide rollers from above, for example, the worker can efficiently perform works of maintenance related to the guide roller housing unit and feeding of the film substrate, or the like through the openings. In order to make access easier, preferably, the upper openings align in the right and left direction, are formed in quantity as possible, and comprise lids (for example, doors) for opening and closing the upper opening respectively. The invention is defined by the claims.

## Claims

1. A deposition device arranged to perform deposition on a surface of a belt-shaped film substrate (10) while conveying the film substrate in the longitudinal direction thereof, the deposition device comprising:
a deposition unit (16), an upstream unit (14) arranged on the upstream side in the conveying direction of the film substrate than the deposition unit, and a downstream unit (18) arranged on the downstream side in the conveying direction of the film substrate than the deposition unit, wherein
the deposition unit has a deposition roller (70) rotatable around a horizontal rotation center axis, a plurality of deposition process devices (84, 88) arranged around the deposition roller, a plurality of guide rollers (72) arranged so as to guide the film substrate between the upstream and downstream units and the deposition roller, a main chamber (64) having a deposition roller housing unit (74) arranged to house the deposition roller and a guide roller housing unit (76) which is located on the upper side thereof and is arranged to house at least a part of the guide rollers, first and second process chambers (66, 68) which are arranged respectively on both sides of the deposition roller housing unit with respect to the right and left direction orthogonal to the direction of the center axis of the deposition roller, which are arranged to house respectively at least a part of the deposition process devices, and which have openings facing the deposition roller housing unit side, and process chamber support units (104) for supporting the first and second process chambers, wherein the deposition roller housing unit has right and left first chamber opening side surfaces (77) which are located on both sides in the right and left direction of the deposition roller and coincide with the openings on the deposition roller housing unit side of the first and second process chambers,
the guide roller housing unit has portions extending to both sides in the right and left direction than the right and left first chamber opening side surfaces of the deposition roller housing unit, and these portions have right and left second chamber opening side surfaces (81, 82) respectively connected to the upstream unit and the downstream unit, and wherein the process chamber support units are configured to support the first and second process chambers such that said chambers are movable between a regular position where the process chambers cover the openings of the deposition roller housing unit and form a deposition space together with the main chamber and a retracted position where the process chambers retract to the outer sides in the right and left direction within a range inside the upstream unit and the downstream unit from the regular position, and between the retracted position and an exposure position which is separated from the retracted position in the front and back direction parallel to the rotation center axis of the deposition roller and from which the interiors of the process chambers are exposed.

2. The deposition device according to claim 1, wherein the process chamber support units are arranged to support the first and second process chambers so as to allow the process chambers to move to the same side with respect to the front and back direction from the retracted position respectively.

3. The deposition device according to claim 2, wherein the process chamber support units are arranged to support the first and second process chambers so as to allow at least one process chamber of the first and second process chambers to move away from the main chamber in the front and back direction by a distance larger than the dimension of the front and back direction of the other process chamber.

4. The deposition device according to claim 1, wherein the process chamber support units include first support units (106) which are arranged to support the first and second process chambers so as to allow the process chambers to move in the right and left direction between the regular position and the retracted position, and second support units (108) which are arranged to support the first support units so as to allow the process chambers to move in the front and back direction between the retracted position and the exposure position.

5. The deposition device according to claim 1, wherein the guide roller housing unit has upper openings (95, 96) for opening each guide roller housed in the guide roller housing unit upwardly, and further comprising scaffolding units (131, 132) which are arranged on at least one side in the front and back direction of the main chamber and used for performing works by a worker through the upper openings.

## Patentansprüche

1. Abscheidungsvorrichtung, die eingerichtet ist, eine Abscheidung auf einer Oberfläche eines bandförmigen Foliensubstrats (10) durchzuführen, während sie das Foliensubstrat in seiner Längsrichtung fördert, wobei die Abscheidungsvorrichtung aufweist:
eine Abscheidungseinheit (16),
eine stromaufwärtige Einheit (14), die auf der stromaufwärtigen Seite in der Förderrichtung des Foliensubstrats bezüglich der Abscheidungseinheit angeordnet ist, und
eine stromabwärtige Einheit (18), die auf der stromabwärtigen Seite in der Förderrichtung des Foliensubstrats bezüglich der Abscheidungseinheit angeordnet ist, wobei
die Abscheidungseinheit eine Abscheidungswalze (70), die um eine horizontale Drehmittelachse drehbar ist, eine Vielzahl von Abscheidungsprozessvorrichtungen (84, 88), die um die Abscheidungswalze angeordnet ist, eine Vielzahl von Führungswalzen (72), die eingerichtet ist, um das Foliensubstrat zwischen den stromaufwärtigen und stromabwärtigen Einheiten und der Abscheidungswalze zu führen, eine Hauptkammer (64), die eine Abscheidungswalzengehäuseeinheit (74), die eingerichtet ist, die Abscheidungswalze aufzunehmen, und eine Führungswalzengehäuseeinheit (76) hat, die auf ihrer oberen Seite angeordnet ist, und eingerichtet ist, mindestens einen Teil der Führungswalzen aufzunehmen, erste und zweite Prozesskammern (66, 68), die jeweils auf beiden Seiten der Abscheidungswalzengehäuseeinheit bezüglich der Rechts- und Linksrichtung angeordnet sind, die senkrecht zu der Richtung der Mittelachse der Abscheidungswalze ist, die eingerichtet sind, jeweils mindestens einen Teil der Abscheidungsprozessvorrichtungen aufzunehmen, und die Öffnungen haben, die der Seite der Abscheidungswalzengehäuseeinheit gegenüberliegen, sowie Prozesskammerhalteeinheiten (104), zum Halten der ersten und zweiten Prozesskammern hat, wobei
die Abscheidungswalzengehäuseeinheit rechte und linke Öffnungsseitenflächen (77) der ersten Kammer hat, die auf beiden Seiten in der Rechts- und Linksrichtung der Abscheidungswalze angeordnet sind und mit den Öffnungen auf der Seite der Abscheidungswalzengehäuseeinheit der ersten und zweiten Prozesskammern übereinstimmen,
die Führungswalzengehäuseeinheit Abschnitte hat, die sich an beiden Seiten in der Rechts- und Linksrichtung bezüglich der rechten und linken Öffnungsseitenflächen der ersten Kammer der Abscheidungswalzengehäuseeinheit erstrecken, und wobei diese Abschnitte rechte und linke Öffnungsseitenflächen (81, 82) der zweiten Kammer haben, die jeweils mit der stromaufwärtigen Einheit und der stromabwärtigen Einheit verbunden sind, und
wobei die Prozesskammerhalteeinheiten eingerichtet sind, die erste und zweite Prozesskammer so zu halten, dass die Kammern zwischen einer normalen Position, in der die Prozesskammern die Öffnungen der Abscheidungswalzengehäuseeinheit abdecken und einen Abscheidungsraum zusammen mit der Hauptkammer ausbilden, und einer zurückgezogenen Position, zu der sich die Prozesskammern von der normalen Position zu den Außenseiten in der Rechts- und Linksrichtung in einem Bereich in der stromaufwärtigen Einheit und der stromabwärtigen Einheit zurückziehen, sowie zwischen der zurückgezogenen Position und einer Freilegungsposition bewegbar sind, die von der zurückgezogenen Position in der Vorwärts- und Rückwärtsrichtung parallel zu der Drehmittelachse der Abscheidungswalze getrennt ist, und von der das Innere der Prozesskammern freiliegend ist.

2. Abscheidungsvorrichtung nach Anspruch 1, wobei die Prozesskammerhalteeinheiten eingerichtet sind, die erste und zweite Prozesskammer zu halten, um es dem Prozesskammern zu ermöglichen, sich jeweils zu derselben Seite bezüglich der Vorwärts- und Rückwärtsrichtung von der zurückgezogenen Position zu bewegen.

3. Abscheidungsvorrichtung nach Anspruch 2, wobei die Prozesskammerhalteeinheiten eingerichtet sind, die erste und zweite Prozesskammer zu halten, um es mindestens einer Prozesskammer der ersten und zweiten Prozesskammern zu ermöglichen, sich von der Hauptkammer in der Vorwärts- und Rückwärtsrichtung um einen Abstand zu bewegen, der größer ist als das Maß der Vorwärts- und Rückwärtsrichtung der anderen Prozesskammer.

4. Abscheidungsvorrichtung nach Anspruch 1, wobei die Prozesskammerhalteeinheiten erste Halteeinheiten (106), die eingerichtet sind, die erste und zweite Prozesskammer zu halten, um es dem Prozesskammern zu ermöglichen, sich in der Rechts- und Linksrichtung zwischen der normalen Position und der zurückgezogenen Position zu bewegen, und zweite Halteeinheiten (108) umfassen, die eingerichtet sind, die ersten Halteeinheiten zu halten, um es den Prozesskammern zu ermöglichen, sich in der Vorwärts- und Rückwärtsrichtung zwischen der zurückgezogenen Position und der Freilegungsposition zu bewegen.

5. Abscheidungsvorrichtung nach Anspruch 1, wobei die Führungswalzengehäuseeinheit obere Öffnungen (95, 96) zum Öffnen jeder Führungswalze nach oben hat, die in der Führungswalzengehäuseeinheit aufgenommen ist, und ferner Gerüsteinheiten (131, 132) aufweist, die auf mindestens einer Seite in der Vorwärts- und Rückwärtsrichtung der Hauptkammer angeordnet sind und zum Durchführen von Arbeiten durch eine Arbeitskraft durch die oberen Öffnungen verwendet werden.

## Revendications

1. Dispositif de dépôt agencé pour réaliser le dépôt, sur une surface, d'un substrat de film en forme de courroie (10) tout en transportant le substrat de film dans sa direction longitudinale, le dispositif de dépôt comprenant :
une unité de dépôt (16), une unité en amont (14) agencée sur le côté en amont dans la direction de transport du substrat de film par rapport à l'unité de dépôt, et une unité en aval (18) agencée sur le côté en aval dans la direction de transport du substrat de film par rapport à l'unité de dépôt, dans lequel :
l'unité de dépôt a un rouleau de dépôt (70) pouvant tourner autour d'un axe central de rotation horizontal, une pluralité de dispositifs de traitement de dépôt (84, 88) agencés autour du rouleau de dépôt, une pluralité de rouleaux de guidage (72) agencés afin de guider le substrat de film entre les unités en amont et en aval et le rouleau de dépôt, une chambre principale (64) ayant une unité de logement de rouleau de dépôt (74) agencée pour loger le rouleau de dépôt et une unité de logement de rouleau de guidage (76) qui est positionnée sur son côté supérieur et est agencée pour loger au moins une partie des rouleaux de guidage, des première et seconde chambres de traitement (66, 68) qui sont respectivement agencées des deux côtés de l'unité de logement de rouleau de dépôt par rapport aux directions droite et gauche orthogonales à la direction de l'axe central du rouleau de dépôt, qui sont agencées pour loger respectivement au moins une partie des dispositifs de traitement de dépôt, et qui ont des ouvertures faisant face au côté de l'unité de logement de rouleau de dépôt, et des unités de support de chambre de traitement (104) pour supporter les première et seconde chambres de traitement,
dans lequel :
l'unité de logement de rouleau de dépôt a des surfaces latérales d'ouverture de première chambre droite et gauche (77) qui sont positionnées des deux côtés dans les directions droite et gauche du rouleau de dépôt et coïncident avec les ouvertures du côté de l'unité de logement de rouleau de dépôt des première et seconde chambres de traitement,
l'unité de logement de rouleau de guidage a des parties s'étendant des deux côtés dans les directions droite et gauche par rapport aux surfaces latérales d'ouverture de première chambre droite et gauche de l'unité de logement de rouleau de dépôt, et ces parties ont des secondes surfaces latérales d'ouverture de chambre droite et gauche (81, 82) respectivement raccordées à l'unité en amont et à l'unité en aval, et
dans lequel les unités de support de chambre de traitement sont configurées pour supporter des première et seconde chambres de traitement de sorte que lesdites chambres sont mobiles entre une position ordinaire dans laquelle les chambres de traitement recouvrent les ouvertures de l'unité de logement de rouleau de dépôt et forment un espace de dépôt conjointement avec la chambre principale et une position rétractée dans laquelle les chambres de traitement se rétractent vers les côtés externes dans les directions droite et gauche dans une plage à l'intérieur de l'unité en amont et l'unité en aval à partir de la position ordinaire, et entre la position rétractée et une position d'exposition qui est séparée de la position rétractée dans les directions avant et arrière parallèlement à l'axe central de rotation du rouleau de dépôt et à partir de laquelle les intérieurs des chambres de traitement sont exposés.

2. Dispositif de dépôt selon la revendication 1, dans lequel les unités de support de chambre de traitement sont agencées pour supporter les première et seconde chambres de traitement afin de permettre aux chambres de traitement de se déplacer du même côté par rapport aux directions avant et arrière, à partir de la position respectivement rétractée.

3. Dispositif de dépôt selon la revendication 2, dans lequel les unités de support de chambre de traitement sont agencées pour supporter les première et seconde chambres de traitement afin de permettre au moins à la chambre de traitement des première et seconde chambres de traitement de s'éloigner de la chambre principale dans les directions avant et arrière selon une distance supérieure à la dimension des directions avant et arrière de l'autre chambre de traitement.

4. Dispositif de dépôt selon la revendication 1, dans lequel les unités de support de chambre de traitement comprennent des premières unités de support (106) qui sont agencées afin de supporter les première et seconde chambres de traitement afin de permettre aux chambres de traitement de se déplacer dans les directions droite et gauche entre la position ordinaire et la position rétractée, et des secondes unités de support (108) qui sont agencées pour supporter les premières unités de support afin de permettre aux chambres de traitement de se déplacer dans les directions avant et arrière entre la position rétractée et la position d'exposition.

5. Dispositif de dépôt selon la revendication 1, dans lequel l'unité de logement de rouleau de guidage a des ouvertures supérieures (95, 96) pour ouvrir chaque rouleau de guidage logé dans l'unité de logement de rouleau de guidage vers le haut, et comprenant en outre des unités d'échafaudage (131, 132) qui sont agencées sur au moins un côté dans les directions avant et arrière de la chambre principale et utilisées pour réaliser des travaux par un ouvrier à travers les ouvertures supérieures.
